# EUROPEAN PATENT APPLICATION

(11) **EP 1 670 083 A2**
(43) Date of publication of application: **14.06.2006**
(21) Application number: 05026618.8
(22) Date of filing: 06.12.2005
(51) Int. Cl.: H01L 51/50, H01L 51/54

(54) **Organic el device**

(30) Priority: 13.12.2004 JP 2004360415
(71) Applicant: KABUSHIKI KAISHA TOYOTA JIDOSHOKKI, Kariya-shi, Aichi-ken (JP)
(72) Inventor: Iijima, Toshiki, K.K. Toyota Jidoshokki, Kariya-shi Aichi-ken (JP); Kawasumi,Kazuhito, K.K. Toyota Jidoshokki, Kariya-shi Aichi-ken (JP); Nagara, Yoshiaki, K.K. Toyota Jidoshokki, Kariya-shi Aichi-ken (JP)
(74) Representative: TBK-Patent

(57) **Abstract**

An organic EL device including between an anode and a cathode an organic layer including: a light-emitting layer containing a fluorescent dopant; a light-emitting layer containing a phosphorescent dopant; and a bipolar layer, in which the bipolar layer is provided between the light-emitting layer containing a fluorescent dopant and the light-emitting layer containing a phosphorescent dopant.

## Description

### FIELD OF THE INVENTION

The present invention relates to an organic electroluminescence (EL) device.

### BACKGROUND OF THE INVENTION

Recently, there are great expectations towards applications of organic EL devices in full-colour display devices. As one method for full-colour display using organic EL devices, a method is known where white light emitted by the devices is divided into red, green, and blue lights by colour filters and the following properties are required in organic EL devices used for such purposes:
i) Good balance amongst the light-emitting intensities of red, green, and blue and resulting good whiteness;
ii) High light-emitting efficiency;
iii) Long lifetime.

In general, an organic EL device has a basic layer structure of anode/organic light-emitting layer/cathode, and further includes arbitrarily layers such as a hole-injecting layer, a hole-transporting layer, an electron-transporting layer, and an electron-injecting layer. In the organic light-emitting layer, holes and electrons recombine to generate excitons, and light emission occurs through the excitons. The thus-generated excitons include singlet excitons and triplet excitons, and the excitons generate in a statistic and theoretical ratio of singlet excitons : triplet excitons of 1 : 3.

Many organic EL devices each have heretofore employed a light-emitting substance generating fluorescence when an exciton in a singlet excited state returns to a ground state. Thus, only 25% of singlet energy is utilized for light emission, and the remaining 75% of triplet energy is eventually consumed as heat. Thus, for efficient utilization of triplet energy for light emission, there are proposed: an organic EL device employing a phosphorescent substance (phosphorescent dopant) for an organic light-emitting layer (JP 2001-284056 A and JP 2002-525808 A, for example); and an organic EL device provided with an exciton-blocking layer formed of an electron-transporting material between a plurality of organic light-emitting layers each containing a phosphorescent dopant (JP 2004-522276 A, for example). Those organic EL devices each have enhanced luminous efficiency of monochromatic light, but are not capable of providing excellent white light emission with favorably balanced intensity among red, green, and blue light emissions.

Thus, there is proposed an organic EL device produced by laminating: an organic light-emitting layer containing a red or green phosphorescent dopant; and an organic light-emitting layer containing a blue fluo-rescent dopant (JP 2004-227814 A, for example) .

However, a conventional organic EL device produced by laminating an organic light-emitting layer containing a phosphorescent dopant and an organic light-emitting layer containing a fluorescent dopant has problems in that triplet energy of the phosphorescent dopant partly transfers to triplet energy of the fluorescent dopant through Dexter transfer to be consumed as heat, and highly efficient light emission cannot be achieved.

### SUMMARY OF THE INVENTION

As described above, no conventional organic EL device satisfies excellent degree of whiteness, luminous efficiency, and device life time.

The present invention has been made in view of solving the above-mentioned problems, and an object of the present invention is therefore to provide an organic EL device with excellent degree of whiteness, luminous efficiency, and device life time.

Thus, the present inventors have conducted extensive research and development for solving the above-mentioned problems. As a result, the present inventors have conceived an effective idea of providing a bipolar layer allowing transfer of holes and electrons (carriers) between a light-emitting layer containing a fluorescent dopant and a light-emitting layer containing a phosphorescent dopant for solving the above-mentioned problems, and have completed the present invention.

An organic EL device according to the present invention includes between an anode and a cathode an organic layer including:
a light-emitting layer containing a fluorescent dopant; a
light-emitting layer containing a phosphorescent dopant; and a
bipolar layer, in which the bipolar layer is provided between the light-emitting layer containing a fluorescent dopant and the light-emitting layer containing a phosphorescent dopant.

Such a structure allows suppression of Dexter transfer of triplet energy while a carrier balance between the light-emitting layer containing a fluorescent dopant and the light-emitting layer containing a phosphorescent layer is maintained.

In the case where the bipolar layer contains a hole-transporting material and an electron-transporting material, the organic EL device according to the present invention is particularly useful. The bipolar layer preferably has a thickness of 2 nm to 15 nm. In this case, the hole-transporting material preferably has a smaller absolute value of highest occupiedmolecular orbital (HOMO) energy level than an absolute value of highest occupied molecular orbitalenergylevelof the electron-transporting material. The hole-transporting material preferably has a smaller absolute value of lowest unoccupied molecular orbital (LUMO) energy level than an absolute value of lowest unoccupied molecular orbital energy level of the electron-transporting material. Further, the hole-transporting material preferably has a higher glass transition temperature than a glass transition temperature of the electron-transporting material. A content of the electron-transporting material is preferably 5 wt% to 95 wt% with respect to the bipolar layer.

Further, the light-emitting layer containing a fluorescent dopant is preferably provided closer to the cathode than the light-emitting layer containing a phosphorescent dopant. The fluorescent dopant is preferably a blue fluorescent dopant. The phosphorescent dopant is preferably at least one phosphorescent dopant selected from a red phosphorescent dopant and a green phosphorescent dopant

The light-emitting layer containing a phosphorescent dopant preferably includes a red phosphorescent dopant and a green phosphorescent dopant. In this case, a content of the red phosphorescent dopant is preferably lower than a content of the green phosphorescent dopant.

The light-emitting layer containing a fluorescent dopant preferably has a larger thickness than a thickness of the light-emitting layer containing a phosphorescent dopant.

The organic layer preferably further includes at least one organic layer selected from a hole-transporting layer containing a material identical to the hole-transporting material of the bipolar layer and an electron-transporting layer containing a material identical to the electron-transporting material of the bipolar layer.

The bipolar layer preferably contains a material having a larger triplet energy gap than a triplet energy gap of the phosphorescent dopant.

### BRIEF DESCRIPTION OF THE DRAWINGS

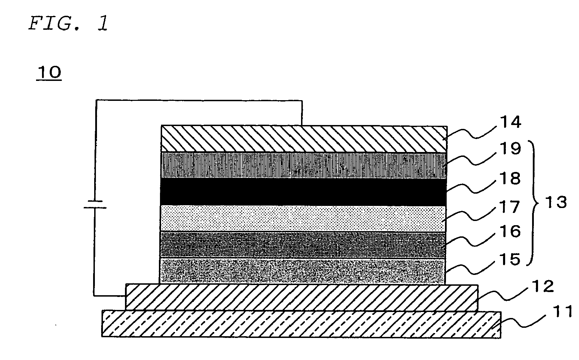

Figure 1 (Fig. 1) is a cross sectional figure to set forth a layer construction example of the present organic EL device.

### DESCRIPTION OF THE PREFERRED EMBODIMENTS

Hereinafter, an organic EL device according to the present invention will be described in more detail with reference to a figure. Fig. 1 is a schematic cross sectional figure of an organic EL device.

As shown in Fig. 1, an organic EL device (10) is produced by sequentially laminating an anode (12), an organic layer (13), and a cathode (14) on a substrate (11). The organic layer (13) is formed to include a hole-transporting layer (15), a light-emitting layer containing a fluorescent dopant (18) (hereinafter, referred to as a fluorescent light-emitting layer (18)), a light-emitting layer containing a phosphorescent dopant (16) (hereinafter, referred to as a phosphorescent light-emitting layer (16)), a bipolar layer (17) provided between the fluorescent light-emitting layer (18) and the phosphorescent light-emitting layer (16), and an electron-transporting layer (19).

First, an organic layer will be described in more detail with reference to Fig. 1.

The organic layer (13) is formed by sequentially laminating the electron-transporting layer (19), the fluorescent light-emitting layer (18), the bipolar layer (17), the phosphorescent light-emitting layer (16), and the hole-transporting layer (15) from a side of the cathode (14) . The bipolar layer (17) allowing transfer of holes and electrons is provided between the fluorescent light-emitting layer (18) and the phosphorescent light-emitting layer (16), to thereby allow suppression of Dexter transfer of triplet energy upon application of a direct voltage between the anode (12) and the cathode (14) without losing a carrier balance.

The fluorescent light-emitting layer (18) is mainly composed of a fluorescent host material and a fluorescent dopant, and is a layer allowing: transport of one or both of holes and electrons injected from the anode (12) and the cathode (14) respectively; recombination of the holes and the electrons for generation of excitons; and generation of fluorescence when the excitons each return to a ground state. Upon excitation of a fluorescent host material, energy transfers through Forster transfer or Dexter transfer, to thereby excite a fluorescent dopant. Further, a fluorescent dopant may be directly excited without energy transfer through the fluorescent host material. Then, fluorescence generates when the fluorescent dopant in a singlet excited state returns to a ground state.

In general, such a fluorescent dopant may be arbitrarily selected from compounds each having a high fluorescence quantum efficiency (Φ).

A blue fluorescent dopant is not particularly limited as long as it has a blue fluorescent light-emitting function. Examples of the blue fluorescent dopant that can be used include: distyrylamine derivatives; pyrene derivatives; perylene derivatives; anthracene derivatives; benzoxazole derivatives; benzothiazole derivatives; benzimidazole derivatives; chrysene derivatives; phenanthrene derivatives; distyrylbenzene derivatives; tetraphenylbutadiene; etc. Of those, 4,4'-bis[2-(9-ethylcarbazol-2-yl)vinyl]biphenyl (BCzVBi), perylene, and the like may be used.

Examples of a fluorescent host material used with the blue fluorescent dopant include: distyrylarylene derivatives; stilbene derivatives; carbazole derivatives; triarylamine derivatives; anthracene derivatives; pyrene derivatives; coronene derivatives; aluminium bis(2-methyl-8-quinolinolate)(p-phenylphenolate) (BAlq), etc.

A red fluorescent dopant is not particularly limited as long as it has a red fluorescent light-emitting function. Examples of the red fluorescent dopant that can be used include: europium complexes; benzopyran derivatives; rhodamine derivatives; benzothioxanthene derivatives; porphyrin derivatives; Nile red; 2-(1,1-dimethylethyl)-6-(2-(2,3,6,7-tetrahydro-1,1,7,7-tetrame thyl-1H,5H-benzo(ij)quinolizin-9-yl)ethenyl)-4H-pyran-4H-ylide ne)propanedinitrile (DCJTB); 4-(dicyanomethylene)-2-methyl-6-(p-dimethylaminostyryl)-4H-pyr an (DCM), etc.

A green fluorescent dopant is not particularly limited as long as it has a green fluorescent light-emitting function. Examples of the green fluorescent dopant that can be used include coumarin derivatives, quinacridone derivatives, etc.

Examples of a fluorescent host material used with the red fluorescent dopant or the green fluorescent dopant include:
distyrylarylene derivatives; distyrylbenzene derivatives; distyrylamine derivatives; quinolinolate-based metal complexes; triarylamine derivatives; oxadiazole derivatives; silole derivatives; dicarbazole derivatives; oligothiophene derivatives; benzopyran derivatives; triazole derivatives; benzoxazole derivatives; benzothiazole derivatives; etc. Specific examples thereof include: aluminium tris(8-quinolinolate) (Alq); a triphenylamine tetramer; 4,4'-bis(2,2'-diphenylvinyl)biphenyl (DPVBi); etc.

A content (doping amount) of the fluorescent dopant is preferably 0.01 wt% to 20 wt%, and more preferably 0.1 wt% to 10 wt% with respect to the fluorescent host material. A content of the blue fluorescent dopant used as a fluorescent dopant is preferably 0.1 wt% to 20 wt% with respect to the fluorescent host material. A content within the above ranges allows fluorescence emission of balanced intensity with intensity of phosphorescence emission from the phosphorescent light-emitting layer (16).

The fluorescent light-emitting layer (18) can be formed by using the above-mentioned fluorescent dopant and fluorescent host material through a known film formation method such as sputtering, ion plating, vacuum vapor deposition, spin coating, electron beam vapor deposition, etc.

The phosphorescent light-emitting layer (16) is mainly composed of a phosphorescent host material and a phosphorescent dopant, and allows recombination of holes and electrons injected from the anode (12) and the cathode (14) respectively to generate singlet excitons and triplet excitons. Singlet excitons of a phosphorescent host material transfer energy to singlet excitons of a phosphorescent dopant, and triplet excitons of the phosphorescent host material transfer energy to triplet excitons of the phosphorescent dopant. The singlet excitons of the phosphorescent dopant convert into triplet excitons through intersystem crossing. Further, a phosphorescent dopant may be directly excited without energy transfer through the phosphorescent host material. In this case, phosphorescence generates when the triplet excitons each returns to a ground state.

Such a phosphorescent dopant may be arbitrarily selected from known phosphorescent dopants each used for a light-emitting layer of an organic EL device.

A blue phosphorescent dopant is not particularly limited as long as it has a blue phosphorescent light-emitting function. Examples of the blue phosphorescent dopant that can be used include metal complexes of iridium, ruthenium, platinum, osmium, rhenium, palladium, etc. Of those, a preferably used metal complex includes at least one ligand having a phenylpyridine skeleton, a bipyridyl skeleton, a porphyrin skeleton, etc. Specific examples of the blue phosphorescent dopant include: iridium bis[4,6-difluorophenylpyridinate-N,C²']picolinate; iridium tris[2-(2,4-difluorophenyl)pyridinate-N,C²']; iridium bis[2-(3,5-trifluoromethyl)pyridinate-N,C^{2'}]picolinate; and iridium bis(4,6-difluorophenylpyridinate-N,C^{2'}) acetylacetonate.

A red phosphorescent dopant is not particularly limited as long as it has a red phosphorescent light-emitting function. Examples of the red phosphorescent dopant that can be used include metal complexes of iridium, ruthenium, platinum, osmium, rhenium, palladium, etc. Of those, a preferably used metal complex includes at least one ligand having a phenylpyridine skeleton, a bipyridyl skeleton, a porphyrin skeleton, etc. Specific examples of the red phosphorescent dopant include: iridium bis[2-(2'-benzo[4,5-α]thienyl)pyridinate-N,C^{3'}] (acetylacetonate) (btp2Ir(acac)); 2,3,7,8,12,13,17,18-octaethyl-12H,23H-porphyrin-platinum(II); iridium bis[2-(2'-benzo[4,5-α]thienyl)pyridinate-N,C³']; and iridium bis(2-phenylpyridine) acetylacetonate.

A green phosphorescent dopant is not particularly limited as long as it has a green phosphorescent light-emitting function. Examples of the green phosphorescent dopant that can be used include metal complexes of iridium, ruthenium, platinum, osmium, rheniurri, palladium, etc. Of those, a preferably used metal complex includes at least one ligand having a phenylpyridine skeleton, a bipyridyl skeleton, a porphyrin skeleton, etc. Specific examples of the green phosphorescent dopant include: iridium fac-tris(2-phenylpyridine) (Ir(ppy)₃); iridiumbis(2-phenylpyridinate-N,C²'] acetylacetonate; and iridium fac-tris[5-fluoro-2-(5-trifluoromethyl-2-pyridine)phenyl-C,N].

A phosphorescent host material is not particularly limited as long as is has higher triplet energy than that of the phosphorescent dopant, and examples thereof include carbazole derivatives, phenanthroline derivatives, triazole derivatives, quinolinolate-based metal complexes, etc. Specific examples thereof include: 4,4'-N,N'-dicarbazole biphenyl (CBP); N-dicarbazolyl-3,5-benzene; poly(9-vinylcarbazole); 4,4',4"-tris(9-carbazolyl)triphenylamine; 4,4'-bis(9-carbazolyl)-2,2'-dimethylbiphenyl; 2,9-dimethyl-4,7-diphenyl-1,10-phenanthroline (BCP); 3-phenyl-4-(1'-naphthyl)-5-phenylcarbazole; aluminium tris(8-quinolinolate) (Alq); and aluminium bis(2-methyl-8-quinolinolate)-4-(phenylphenolate).

A content (doping amount) of the phosphorescent dopant is preferably 0.01 wt% to 30 wt%, and more preferably 0.1 wt% to 20 wt% with respect to the phosphorescent host material. A content of the red phosphorescent dopant used as a phosphorescent dopant is preferably 0.1 wt% to 20 wt% with respect to the phosphorescent host material. A content of the green phosphorescent dopant used as a phosphorescent dopant is preferably 0.1 wt% to 20 wt% with respect to the phosphorescent host material. A content within the above ranges allows phosphorescence emission of balanced intensity with intensity of fluorescence emission from the fluorescent light-emitting layer (18).

Addition of a plurality of phosphorescent dopants into the same phosphorescent light-emitting layer allows: energy transfer from a phosphorescent host material to a first phosphorescent dopant of low energy; and efficient energy transfer to a second phosphorescent dopant of lower energy. In particular, addition of a red phosphorescent dopant and a green phosphorescent dopant into the same phosphorescent light-emitting layer allows improvement in luminous efficiency. In this case, a content of the red phosphorescent dopant is preferably lower than that of the green phosphorescent dopant from the viewpoint of improving luminous efficiency.

Further, the phosphorescent light-emitting layer (16) may have a structure of two or more layers with different phosphorescent dopants added thereto.

The phosphorescent light-emitting layer (16) can be formed by using the above-mentioned phosphorescent dopant and phosphorescent host material through a known film formation method such as sputtering, ion plating, vacuum vapor deposition, electron beam vapor deposition, etc.

In consideration of device properties such as degree of whiteness, device life time, and luminous efficiency, a blue fluorescent dopant is preferably used as a fluorescent dopant. Further, at least one phosphorescent dopant selected from a red phosphorescent dopant and a green phosphorescent dopant is preferably used.

Athickness of the fluorescent light-emitting layer (18) varies depending on a material to be selected, but is preferably 1 nm to 100 nm, and more preferably 2 nm to 50 nm. The fluorescent light-emitting layer (18) has a larger thickness than that of the phosphorescent light-emitting layer (16), to thereby provide a favorable intensity balance between fluorescence emission and phosphorescence emission and improve degree of whiteness of an organic EL device.

A thickness of the phosphorescent light-emitting layer (16) varies depending on a material to be selected, but is preferably 0.1 nm to 100 nm, and more preferably 3 nm to 15 nm.

The bipolar layer (17) is composed of a material allowing transfer of holes and electrons injected from the anode (12) and the cathode (14) respectively, and is a layer for securing a specific distance between the fluorescent light-emitting layer (18) and the phosphorescent light-emitting layer (16) and suppressing Dexter transfer of triplet energy of the phosphorescent light-emitting layer (16) to the fluorescent light-emitting layer (18).

A material to be used for the bipolar layer (17) is not particularly limited as long as it allows transfer of holes and electrons (has bipolar property). Examples thereof include: a single material having bipolar property; and a mixture of a hole-transporting material and an electron-transporting material.

A material having a larger triplet energy gap than that of the phosphorescent dopant is selected as a material for forming the bipolar layer (17), to thereby suppress energy transfer of triplet energy of the phosphorescent host material to the material used for the bipolar layer (17). In the present invention, the triplet energy gap is defined as an energy difference between a ground state and a triplet excited state of a material.

Examples of a single material having bipolar property include carbazole derivatives, fluorene derivatives, etc. Specific examples thereof include: 4,4'-N,N'-dicarbazole biphenyl (CBP); and N,N'-dicarbazolyl-3,5-benzene.

In the bipolar layer (17) formed of a mixture of a hole-transporting material and an electron-transporting material, the hole-transporting material may employ an arbitrary material selected from known materials and the like used for hole-transporting layers of organic EL devices.

Examples of the material include: phthalocyanine derivatives; triazole derivatives; triarylmethane derivatives; triarylamine derivatives; oxazole derivatives; oxadiazole derivatives; hydrazone derivatives; stilbene derivatives; pyrazoline derivatives; polysilane derivatives; imidazole derivatives; phenylenediamine derivatives; amino-substituted chalcone derivatives; styryl compounds such as styrylanthracene derivatives or styrylamine derivatives; fluorene derivatives; silazane derivatives; aniline-based copolymers; porphyrin compounds; carbazole derivatives; polyarylalkane derivatives; polyphenylene vinylenes and derivatives thereof; polythiophenes and derivatives thereof; poly-N-vinylcarbazole derivatives; conductive polymer oligomers such as thiophene oligomers; aromatic tertiary amine compounds; styrylamine compounds; triamines; tetraamines; benzidines; arylene diamine derivatives; paraphenylene diamine derivatives; metaphenylene diamine derivatives; 1,1-bis(9-diarylaminophenyl)cyclohexanes; 4,4'-di(dia rylamino)biphenyls; bis[4-(diarylamino)phenyl]methanes; 4,4"-di(diarylamino)terphenyls; 4,4"'-di(diarylamino)quaterphenyls; 4,4'-di(diarylamino)diphenyl ethers; 4,4'-di(diarylamino)diphenyl sulfanes; bis[4-(diarylamino)phenyl]dimethylmethanes; bis[4-(diarylamino)phenyl]-di(trifluoromethyl)methanes; styryl compounds; and 2,2-diphenylvinyl compounds.

Examples of the triarylamine derivatives include: dimers, trimers, tetramers, or pentamers of triphenylamine; 4,4'-bis[N-phenyl-N-(4"-methylphenyl)amino]biphenyl; 4,4'-bis[N-phenyl-N-(3"-methylphenyl)amino]biphenyl; 4,4'-bis[N-phenyl-N-(3"-methoxyphenyl)amino]biphenyl; N,N'-diphenyl-N,N'-bis(1-naphthyl)-(1,1'-biphenyl)-4,4'-diamin e (NPB); 4,4'-bis[N-[4'-[N"-(1-naphthyl)-N"-phenylamino]biphenyl-N-phen ylamino]biphenyl (NTPA); 3,3'-dimethyl-4,4'-bis[N-phenyl-N-(3"-methylphenyl)amino]biphe nyl; 1,1-bis[4'-[N,N-di(4"-methylphenyl)amino]phenyl]cyclohexane; 9,10-bis[N-(4'-methylphenyl)-N-(4"-n-butylphenyl)amino]phenant hrene; 3,8-bis(N,N-biphenylamino)-6-phenylphenanthridine; 4-methyl-N,N-bis[4",4"'-bis[N',N"-di(4-methylphenyl)amino]biph en-4-yl]aniline; N,N"-bis[4-(diphenylamino)phenyl]-N,N'-diphenyl-1,3-diaminoben zene; N,N'-bis[4-(diphenylamino)phenyl]-N,N'-diphenyl-1,4-diaminoben zene; 5,5"-bis[4-(bis[4-methylphenyl]amino)phenyl]-2,2':5'2"-terthio phene; 1,3,5-tris(diphenylamino)benzene; 4,4',4"-tris(N-carbazolyl)triphenylamine; 4,4',4"-tris[N-(3"'-methylphenyl)-N-phenylamino]triphenylamine ; 4,4',4"-tris[N,N-bis(4' "-tert-butylbiphen-4" "-yl)amino]triphen ylamine; and 1,3,5-tris[N-(4'-diphenylaminophenyl)-N-phenylamino]benzene.

Examples of the porphyrin compound include: porphyrin; 1,10,15,20-tetraphenyl-21H,23H-porphyrin copper(II); 1,10,15,20-tetraphenyl-21H,23H-porphyrin zinc(II); and 5,10,15,20-tetrakis(pentafluorophenyl)-21H,23H-porphyrin. Examples of the phthalocyanine derivatives include: silicon phthalocyanine oxide; aluminum phthalocyanine chloride; nonmetal phthalocyanines; dilithium phthalocyanine; copper tetramethylphthalocyanine; copper phthalocyanine; chromium phthalocyanine; zinc phthalocyanine; lead phthalocyanine; titanium phthalocyanine oxide; magnesium phthalocyanine; and copper octamethylphthalocyanine.

Examples of the aromatic tertiary amine compound and styryl compound include: N,N,N',N'-tetraphenyl-4,4'-diaminobiphenyl; N,N'-diphenyl-N,N'-bis(3-methylphenyl)-[1,1'-biphenyl]-4,4'-di amine; 2,2-bis(4-di-p-tolylaminophenyl)propane; 1,1-bis(4-di-p-tolylaminophenyl)cyclohexane; N,N,N',N'-tetra-p-tolyl-4,4'-diaminobiphenyl; 1,1-bis(4-di-p-tolylaminophenyl)-9-phenylcyclohexane; bis(4-dimethylamino-2-methylphenyl)phenylmethane; bis(4-di-p-tolylaminophenyl)phenylmethane; N,N'-diphenyl-N,N'-di(4-methoxyphenyl)-4,4'-diaminobiphenyl; N,N,N',N'-tetraphenyl-4,4'-diaminophenyl ether; 4,4'-bis(diphenylamino)quadriphenyl; N,N,N-tri(p-tolyl)amine; 4-(di-p-tolylamino)-4'-[4(di-p-tolylamino)styryl]stilbene; 4-N,N-diphenylamino-2-diphenylvinyl benzene; 3-methoxy-4'-N,N-diphenylaminostyrylbenzene; and N-phenylcarbazole.

Of those, preferred examples of the material include:
aryl-di(4-diarylaminophenyl)amines; paraphenylene diamine derivatives; 4,4'-diaminobiphenyl derivatives; 4,4'-diaminodiphenylsulfane derivatives; 4,4'-diaminodiphenylmethane derivatives; 4,4'-diaminodiphenyl ether derivatives; 4,4'-diaminotetraphenylmethane derivatives; 4,4'-diaminostilbene derivatives; 1,1-diarylcyclohexanes; 4,4"-diaminoterphenyl derivatives; 5,10-di-(4-aminophenyl)anthracene derivatives; 2,5-diarylpyridines; 2,5-diarylfurans; 2,5-diarylthiophenes; 2,5-diarylpyrroles; 2,5-diaryl-1,3,4-oxadiazoles; 4-(diarylamino)stilbenes; 4,4'-di(diarylamino)stilbenes; N,N-diaryl-4-(2,2-diphenylvinyl)anilines; 2,5-diaryl-1,3,4-triazoles; 1,4-di(4-aminophenyl)naphthalene derivatives; 2,8-di(diarylamino)-5-thioxanthanes; and 1,3-di(diarylamino)isoindoles. More preferred examples of the material include:
   tris[4-[N-(3-methylphenyl)-N-phenylamino]phenyl]amine and tris[4-[N-(2-naphthyl)-N-phenylamino]phenyl]amine.

In the bipolar layer (17) formed of a mixture of a hole-transporting material and an electron-transporting material, the electron-transporting material may employ an arbitrary material selected from known materials and the like used for electron-transporting layers of organic EL devices.

Examples of the material include oxadiazole derivatives such as 1,3-bis[5'-(p-tert-butylphenyl)-1,3,4-oxadiazol-2'-yl]benzene or 2-(4-biphenylyl)-5-(4-tert-butylphenyl)-1,3,4-oxadiazole; triazole derivatives such as 3-(4'-tert-butylphenyl)-4-phenyl-5-(4"-biphenyl)-1,2,4-triazol e; triazine derivatives; quinoline derivatives; quinoxaline derivatives; diphenylquinone derivatives; nitro-substituted fluorenone derivatives; thiopyran dioxide derivatives; anthraquino-dimethane derivatives; heterocyclic tetracarboxylic anhydrides such as naphthalene perylene; carbodiimide; fluorenylidene methane derivatives; anthrone derivatives; distyrylpyrazine derivatives; silole derivatives; phenanthroline derivatives; imidazopyridine derivatives; etc.

Further examples thereof include: organometallic complexes such as bis(10-benzo[h]quinolinolate)beryllium, a beryllium salt of 5-hydroxyflavone, or aluminum salts of 5-hydroxyflavone; and metal complexes of 8-hydroxyquinoline or its derivatives. Examples of the metal complexes of 8-hydroxyquinoline or its derivatives include metal chelate oxinoid compounds such as oxines each containing a chelate of a quinolinolate-based metal complexs such as: aluminium tris(8-quinolinolate) (Alq); aluminium tris(5,7-dichloro-8-quinolinolate); aluminium bis(2-methyl-8-quinolinolate)(p-phenylphenolate) (BAlq); aluminium tris(5,7-dibromo-8-quinolinolate); and aluminium tris(2-methyl-8-quinolinolate). Further examples thereof include the above-mentioned metal complexes each having a central metal substituted by iridium, indium, magnesium, copper, calcium, tin, zinc, or lead. Further examples of the material include: metal-free or metal phthalocyanines; and metal-free or metal phthalocyanines each having a terminal substituted by an alkyl group, a sulfone group, etc.

Of those, more preferred examples of the material include: 2,9-dimethyl-4,7-diphenyl-1,10-phenanthroline (BCP); and 3-phenyl-4-(1'-naphthyl)-5-phenyl-1,2,4-triazole (TAZ). A hole-transporting material having a higher glass transition temperature (Tg) than that of the electron-transporting material is selected, to thereby prevent change in color of light emission from a device and reduction in luminous efficiency. Thus, degradation of device properties upon continuous light emission from the device can be prevented.

A content of the above-mentioned electron-transporting material is preferably 5 wt% to 95 wt%, and more preferably 20 wt% to 80 wt% with respect to the bipolar layer (17). A content of the electron-transporting material of less than 5 wt% with respect to the bipolar layer (17) suppresses transfer of holes from the phosphorescent light-emitting layer (16) to the fluorescent light-emitting layer (18) and inhibits highly efficient emission of white light. In contrast, a content of the electron-transporting material of more than 95 wt% with respect to the bipolar layer (17) allows excessive transfer of electrons from the phosphorescent light-emitting layer (16) to the fluorescent light-emitting layer (18) and inhibits highly efficient emission of white light. Thus, a content of the electron-transporting material in the bipolar layer (17) within the above ranges allows production of an organic EL device with high luminous efficiency and excellent degree of whiteness.

In the case where the bipolar layer (17) is formed as a mixed layer of a hole-transporting material and an electron-transporting material, materials for the hole-transporting material and the electron-transporting material are preferably selected so that the hole-transporting material has a smaller absolute value of HOMO energy level than an absolute value of HOMO energy level of the electron-transporting material. Further, materials for the hole-transporting material and the electron-transporting material are preferably selected so that the hole-transporting material has a smaller absolute value of LUMO energy level than an absolute value of LUMO energy level of the electron-transporting material. Such a structure provides a sufficient bipolar function and allows further improvement in luminous efficiency.

In the present invention, the HOMO energy level and ionization potential, and the LUMO energy level and electron affinity are defined to be identical, respectively. The ionization potential and the electron affinity are defined based on vacuum level as a reference.

The ionization potential (HOMO) can be determined by: directly measuring the ionization potential through photoelectron spectroscopy or a similar measurement method; or correcting an electrochemically measured oxidation potential with respect to a reference electrode.

The electron affinity (LUMO) can be determined by subtracting a band gap value, that is, energy of an absorption edge of an absorption spectrum from the ionization potential (HOMO).

The bipolar layer (17) can be formed by using the above-mentioned materials through a known film formation method such as vacuum vapor deposition, sputtering, ionization vapor deposition, ion plating, electron beam vapor deposition, spin coating, etc. In this case, the bipolar layer (17) has a thickness of preferably 2 nm to 15 nm, and more preferably 4 nm to 10 nm. Formation of the bipolar layer (17) with a thickness of 1 nm or less degrades a function of suppressing Dexter transfer of triplet energy of the bipolar layer (17). In contrast, formation of the bipolar layer (17) with a thickness of 15 nm or more increases a driving voltage of an organic EL device. Thus, a thickness of the bipolar layer (17) is adjusted within the above ranges, to thereby secure a distance between the fluorescent light-emitting layer (18) and the phosphorescent light-emitting layer (16) and efficiently suppress transfer of the triplet energy.

The hole-transporting layer (15) is a layer for transporting holes injected from the anode to the phosphorescent light-emitting layer (16) . The hole-transporting layer (15) provides an organic EL device with the following properties:
(i) To reduce driving voltage;
(ii) To extend device life time by stabilization of hole injection from the anode (12) to the phosphorescent light-emitting layer (16);
(iii) To enhance uniformity of a light-emitting surface by increased adhesiveness between the anode (12) and the phosphorescent light-emitting layer (16);
(iv) To cover projections and the like of the anode (12) to reduce device defects.

A material to be used for the hole-transporting layer (15) is not particularly limited as long as the material provides the hole-transporting layer (15) with the above-mentioned properties. The material may be arbitrarily selected from the above-mentioned hole-transporting material used for the bipolar layer (17) and known materials used for a hole-injecting material of a photoconductive material. In particular, a material identical to the hole-transporting material included in the bipolar layer (17) is preferably used costwise.

The hole-transporting layer (15) may be formed of one kind of material described above, or formed of a mixture of a plurality of materials described above. Further, the hole-transporting layer (15) may have a multilayer structure composed of a plurality of layers with the same composition or different compositions.

The hole-transporting layer (15) can be formed by using the above-mentioned material through a known film formation method such as sputtering, ion plating, vacuum vapor deposition, spin coating, electron beam vapor deposition, etc. A thickness of the hole-transporting layer (15) varies depending on a material to be used, but is generally 5 nm to 5 µm.

HOMO of the hole-transporting layer (15) is generally set between a work function of an anode and HOMO of a light-emitting layer is provided.. In the case where the hole-transporting layer (15) is provided closer to a side of light emission than an adjacent light-emitting layer is provided, the hole-transporting layer (15) is formed transparent to light to be emitted. Thus, of the materials capable of forming the hole-transporting layer (15), a material capable of forming a thin film transparent to the light to be emitted is arbitrarily selected, and the thin film is generally formed to have a transmittance of more than 10% with respect to light to be emitted.

The electron-transporting layer (19) is a layer provided between the cathode (14) and the fluorescent light-emitting layer (18) for transporting electrons injected from the cathode (14) to the fluorescent light-emitting layer (18). The electron-transporting layer (19) provides an organic EL device with the following properties:
(i) To reduce driving voltage;
(ii) To extend device life time by stabilization of electron injection from the cathode (14) to the fluorescent light-emitting layer (18);
(iii) To enhance uniformity of a light-emitting surface by increased adhesiveness between the cathode (14) and the fluorescent light-emitting layer (18).

A material to be used for the electron-transporting layer (19) is not particularly limited as long as the material provides the electron-transporting layer (19) with the above-mentioned properties. The material may be arbitrarily selected from the above-mentioned electron-transporting material used for the bipolar layer (17) and known materials used for an electron-injecting material of a photoconductive material. In general, a material preferably used has LUMO between a work function of the cathode and LUMO of an adjacent light-emitting layer. In particular, a material identical to the electron-transporting material included in the bipolar layer (17) is preferably used costwise for formation of the electron-transporting layer (19).

The electron-transporting layer (19) may be formed of one kind of material described above, or formed of a mixture of a plurality of materials described above. Further, the electron-transporting layer (19) may have a multilayer structure composed of a plurality of layers with the same composition or different compositions.

The electron-transporting layer (19) can be formed by using the above-mentioned material through a known film formation method such as sputtering, ion plating, vacuum vapor deposition, spin coating, electron beam vapor deposition, etc. A thickness of the electron-transporting layer (19) varies depending on a material to be used, but is generally 5 nm to 5 µm.

In the case where the electron-transporting layer (19) is provided closer to a side of light emission than an adjacent light-emitting layer is provided, the electron-transporting layer (19) is formed transparent to light to be emitted. Thus, of the materials capable of forming the electron-transporting layer (19), a material capable of forming a thin film transparent to the light to be emitted is arbitrarily selected, and the thin film is generally formed to have a transmittance of more than 10% with respect to light to be emitted.

Next, the substrate, the anode, and the cathode will be described in more detail.

The substrate (11) is a plate-like member for supporting an organic EL device. Each of the layers forming the organic EL device is very thin, and thus the organic EL device is generally produced as an organic EL device supported on the substrate (11). For this purpose, the substrate (11) preferably has surface smoothness. In the case where the substrate (11) is provided on a side of light emission, the substrate (11) is used transparent to light to be emitted.

A known substrate may be used as the substrate (11) as long as it has the above-mentioned properties. Examples thereof include: a ceramics substrate such as a glass substrate, a silicon substrate, or a quartz substrate; a plastic substrate; and a metal substrate. A substrate having a metal foil formed thereon or the like may also be used. A hybrid substrate prepared by combining the same kind or different kinds of substrates may also be used.

The anode (12) is an electrode for injecting holes into the organic layer (13). Thus, a material to be used for the anode (12) has only to be a material capable of providing the anode (12) with this property. In general, a known material such as a metal, an alloy, a conductive compound, or a mixture thereof is selected.

Examples of the material to be used for the anode (12) include metal oxides or metal nitrides such as indium tin oxide (ITO), indium zinc oxide (IZO), indium tungsten oxide (IWO), tin oxide, zinc oxide, zinc aluminum oxide, or titanium nitride; a metal, alloy thereof, or other alloy such as gold, platinum, silver, copper, aluminum, nickel, cobalt, lead, chromium, molybdenum, tungsten, tantalite, niobium, or copper iodide; and a conductive polymer such as polyaniline, polythiophene, polypyrrole, polyphenylene vinylene, poly(3-methylthiophene), or polyphenylene sulfide.

In the case where the anode (12) is provided closer to a side of light emission than the organic layer (13) is provided, the anode (12) is generally formed to have a transmittance of more than 10% with respect to light to be emitted. In the case where light of a visible light region is to be emitted, ITO having high transmittance in a visible light region is preferably used.

In the case where the anode (12) is used as a reflective electrode, a material having property of reflecting light emitted to inside or outside is arbitrarily selected from the above-mentioned materials. In general, a metal, an alloy, or a metal compound is selected.

The anode (12) may be formed of one kind of material described above, or formed of a mixture of a plurality of materials described above. Further, the anode (12) may have a multilayer structure composed of a plurality of layers with the same composition or different compositions. The anode (12) can be formed by using the above-mentioned material through a known film formation method such as sputtering, ion plating, vacuum vapor deposition, spin coating, electron beam vapor deposition, etc.

A thickness of the anode (12) varies depending on a material to be used, but is generally 5 nm to 1 µm, preferably 10 nm to 1 µm, more preferably 10 nm to 500 nm, particularly preferably 10 nm to 300 nm, and most preferably 10 nm to 200 nm.

The anode (12) is set to have a sheet electrical resistance of preferably several hundreds Ω /sheet or less, and more preferably 5Ω/sheet to 50Ω/sheet.

A surface of the anode (12) (surf ace in contact with the organic layer (13)) is preferably subjected to UV ozone cleaning, oxygen plasma cleaning, or argon plasma cleaning. For suppression of short circuits or defects of the organic EL device, a surface roughness of the anode (12) is preferably controlled to a root mean square of 2 nm or less through a method of reducing a particle size or a method of polishing after film formation.

In the case where the anode (12) has a high resistance, an auxiliary electrode may be provided to reduce the resistance. The auxiliary electrode is an electrode formed of a metal such as silver, copper, chromium, aluminum, titanium, an aluminum alloy, or a silver alloy, or a laminate thereof partly provided on the anode (12).

The cathode (14) is an electrode for injecting electrons into the organic layer (13) . An electrode material composed of a metal, alloy, conductive compound, or mixture thereof having a small work function is preferably used for the cathode (14), and an electrode material having a work function of less than 4.5 eV is preferably used for injecting electron efficiency. Examples of the electrode material include lithium, sodium, magnesium, gold, silver, copper, aluminum, indium, calcium, tin, ruthenium, titanium, manganese, chromium, yttrium, an aluminum-calcium alloy, an aluminum-lithium alloy, an aluminum-magnesium alloy, a magnesium-silver alloy, a magnesium-indium alloy, a lithium-indium alloy, a sodium-potassium alloy, a magnesium/copper mixture, and an aluminum/aluminum oxide mixture. Further, a material used for an anode may also be used.

In the case where the cathode (14) is provided closer to a side of light emission than the organic layer (13) is provided, the cathode (14) is generally formed to have a transmittance of more than 10% with respect to light to be emitted, and a transparent conductive oxide is laminated thereon.

In the case where the cathode (14) is used as a reflective electrode, a material having property of reflecting light emitted to inside or outside is arbitrarily selected from the above-mentioned materials. In general, a metal, an alloy, or a metal compound is selected.

The cathode (14) may be formed of a single material described above, or formed of a plurality of materials described above. For example, addition of 5% to 10% silver or copper to magnesium prevents oxidation of the cathode (14) and enhances adhesiveness of the cathode (14) to the organic layer (13).

The cathode (14) can be formed by using the above-mentioned material through a known film formation method such as vacuum vapor deposition, sputtering, ionization vapor deposition, ion plating, electron beam vapor deposition, etc.

A thickness of the cathode (14) varies depending on a material to be used, but is generally 5 nm to 1 µm, preferably 10 nm to 500 nm, and most preferably 50 nm to 200 nm.

The cathode (14) is set to have a sheet electrical resistance of preferably several hundreds Ω/sheet or less.

For display of white color from the above-mentioned laminate structure,the phosphorescentlight-emittinglayer(16),thebipolar layer (17), and the fluorescent light-emitting layer (18) may be formed into the following layer structures between the cathode and the anode.
(i) blue fluorescent light-emitting layer / bipolar layer/ red and green phosphorescent light-emitting layer
(ii) blue fluorescent light-emitting layer / bipolar layer/ redphosphorescent light-emitting layer / green phosphorescent light-emitting layer
(iii) blue fluorescent light-emitting layer / bipolar layer/ green phosphorescent light-emitting layer/ red phosphorescent light-emitting layer
(iv) blue fluorescent light-emitting layer / bipolar layer/ red fluorescent light-emitting and green phosphorescent light-emitting layer
(v) blue fluorescent light-emitting layer / bipolar layer/ green fluorescent light-emitting and red phosphorescent light-emitting layer
(vi) blue fluorescent light-emitting layer / red fluorescent light-emitting layer / bipolar layer/ green phosphorescent light-emitting layer
(vii) blue fluorescent light-emitting layer / green fluorescent light-emitting layer / bipolar layer/ red phosphorescent light-emitting layer
(viii) blue fluorescent light-emitting layer / bipolar layer/ red phosphorescentlight-emittinglayer/bipolarlayer/green fluorescent light-emitting layer
(ix) blue fluorescent light-emitting layer / bipolar layer/ green phosphorescent light-emitting layer / bipolar layer/ red fluorescent light-emitting layer
(x) green phosphorescent light-emitting layer / bipolar layer/ blue fluorescent light-emitting layer / bipolar layer/ red phosphorescent light-emitting layer
(xi) green fluorescent light-emitting layer / blue fluorescent light-emitting layer / bipolar layer/ red phosphorescent light-emitting layer
(xii) green phosphorescent light-emitting layer / bipolar layer/ blue fluorescent light-emitting layer / red fluorescent light-emitting layer.

Of those, a device structure including the fluorescent light-emitting layer (18) provided closer to the cathode than the phosphorescent light-emitting layer (16) is provided can realize excellent degree of whiteness and luminous efficiency.

The above-mentioned layer structures each display white color by using red color, green color, and blue color. However, light of complementary colors may be emitted to display white color from device structures such as blue light-emitting layer/yellow light-emitting layer, light blue light-emitting layer/orange light-emitting layer, and green light-emitting layer/violet light-emitting layer. Color except white color may obviously be displayed.

The organic layer of the organic EL device is not limited to a layer consisting of five layers including the above-mentioned hole-transporting layer (15), fluorescent light-emitting layer (18), phosphorescent light-emitting layer (16), bipolar layer (17), and electron-transporting layer (19). The organic layer may include a known layer in an organic EL device, or may omit some layers.

Specific examples of the device structure are shown below.
(i) (anode)/ (fluorescent light-emitting layer, phosphorescent light-emitting layer, bipolar layer)/ (cathode)
(ii) (anode)/ (fluorescent light-emitting layer, phosphorescent light-emitting layer, bipolar layer)/ electron-transporting layer/ (cathode)
(iii) (anode)/ (fluorescent light-emitting layer, phosphorescent light-emitting layer, bipolar layer)/ electron-transporting layer/ electron-injecting layer/ (cathode)
(iv) (anode)/ hole-transporting layer/ (fluorescent light-emitting layer, phosphorescent light-emitting layer, bipolar layer)/ (cathode)
(v) (anode)/ hole-transporting layer/ (fluorescent light-emitting layer, phosphorescent light-emitting layer, bipolar layer)/ electron-transporting layer/ (cathode)
(vi) (anode)/ hole-transporting layer/ (fluorescent light-emitting layer, phosphorescent light-emitting layer, bipolar layer)/ electron-transporting layer/ electron-injecting layer/ (cathode)
(vii) (anode) / hole-injecting layer/ hole-transporting layer/ (fluorescent light-emitting layer, phosphorescent light-emitting layer, bipolar layer)/ (cathode)
(viii) (anode)/ hole-injecting layer/ hole-transporting layer/ (fluorescent light-emitting layer, phosphorescent light-emitting layer, bipolar layer) / electron-transporting layer/ (cathode)
(ix) (anode)/ hole-injecting layer/ hole-transporting layer/ (fluorescent light-emitting layer, phosphorescent light-emitting layer, bipolar layer) / electron-transporting layer/ electron-injecting layer/ (cathode)

The hole-injecting layer is a layer formed between the anode and the hole-transporting layer for transporting holes injected from the anode to the hole-transporting layer. The hole-injecting layer provides an organic EL device with the following properties:
(i) To reduce driving voltage;
(ii) To extend device life time by stabilization of hole injection from the anode to the hole-transporting layer;
(iii) To enhance uniformity of a light-emitting surface by increased adhesiveness between the anode and the hole-transporting layer;
(iv) To cover projections and the like of the anode to reduce device defects.

A material to be used for the hole-injecting layer is not particularly limited as long as the material provides the hole-injecting layer with the above-mentioned properties. The material may employ a material used for the above-mentioned hole-transporting layer (15) or a known material as it is. The hole-injecting layer may be formed of a single material, or formed of a plurality of materials.

The hole-injecting layer has a thickness of 0.1 nm to 100 nm, and preferably 0.3 nm to 50 nm.

The electron-injecting layer is a layer formed between the cathode (14) and the electron-transporting layer (19) for transporting electrons injected from the cathode (14) to the electron-transporting layer (19). The electron-injecting layer provides an organic EL device with the following properties:
(i) To reduce driving voltage;
(ii) To extend device life time by stabilization of electron injection from the cathode (14) to the electron-transporting layer (19) ;
(iii) To enhance uniformity of a light-emitting surface by increased adhesiveness between the cathode (14) and the electron-transporting layer (19).

A material to be used for the electron-injecting layer is not particularly limited as long as the material provides the electron-injecting layer with the above-mentioned properties, and a known material may also be used. Examples of the material include fluorides, oxides, chlorides, and sulfides of alkali metals and alkali earth metals such as lithium fluoride, lithium oxide, magnesiumfluoride, calciumfluoride, strontium fluoride, andbarium fluoride. The electron-injecting layer may be formed of a single material, or formed of a plurality of materials.

The electron-injecting layer has a thickness of 0.1 nm to 10 nm, and preferably 0.3 nm to 3 nm.

The electron-injecting layer may be formed to have a uniform thickness across the electron-injecting layer, may be formed to have non-uniform thicknesses across the electron-injecting layer, or may be formed into islands through a known film formation method such as vacuum vapor deposition.

Next, description will be given of layers which may be provided between the above-mentioned layers.

A layer blocking transfer of holes, electrons, or the like (blocking layer) maybe provided between at least two above-mentioned layers. For example, in the case where the fluorescent light-emitting layer is provided closer to the cathode than the bipolar layer is provided, a hole-blocking layer may be provided adjacent to the fluorescent light-emitting layer on the side of the cathode. Provision of a hole-blocking layer suppresses transfer of holes to the side of the cathode and allows efficient recombination of the holes and electrons in the fluorescent light-emitting layer, to thereby improve luminous efficiency.

Examples of a material to be used for the hole-blocking layer include known materials such as triazole derivative, oxadiazole derivatives, BAlq, phenanthroline derivatives. In particular, a material identical to the electron-transporting material included in the bipolar layer is used, to thereby improve luminous efficiency without shortening the device life time.

A protective layer (sealing layer or passivation film) may be provided on a side opposite to the substrate for preventing the organic EL device from contacting with oxygen or moisture.

Examples of a material to be used for the protective layer include an organic polymer material, an inorganic material, a photo-curable resin, and a thermosetting resin. A single material may be used alone as a material used for the protective layer, and a plurality of materials may be used in combination. The protective layer may have a single layer structure or a multilayer structure.

Examples of the organic polymer material include: a fluorine-based resin such as a chlorotrifluoroethylene polymer, a dichlorodifluoroethylene polymer, or a copolymer of a chlorotrifluoroethylene polymer and a dichlorodifluoroethylene polymer; an acrylic resin such as polymethylmethacrylate or polyacrylate; an epoxy resin; a silicon resin; an epoxy silicone resin; a polystyrene resin; a polyester resin; a polycarbonate resin; a polyamide resin; a polyimide resin; a polyamideimide resin; a polyparaxylene resin; a polyethylene resin; and a polyphenylene oxide resin.

Examples of the inorganic material include polysilazane, a diamond thin film, amorphous silica, electrically insulating glass, a metal oxide, a metal nitride, a metal hydrocarbon, and a metal sulfide.

The organic EL device may be protected by being sealed in an inert substance such as paraffin, liquid paraffin, silicone oil, fluorocarbon oil, or zeolite-added fluorocarbon oil.

The organic EL device may obviously be protected by can sealing. To be specific, an organic layer may be sealed by a sealing member such as a sealing sheet or a sealing vessel for blocking moisture and oxygen from the outside. The sealing member may be provided on a side of an electrode on a back surface, or an entire organic EL device may be covered with the sealing member. The shape, size, thickness, and the like of the sealing member are not particularly limited as long as the organic layer may be sealed and outside air may be blocked. Examples of a material to be used for the sealing member include glass, stainless steel, a metal (such as aluminum), a plastic (such as polychlorotrifluoroethylene, polyester, or polycarbonate), or ceramics.

In the case where the sealing member is provided for the organic EL device, a sealing agent (adhesive) may be arbitrarily used. In the case where the entire organic EL device is covered with sealing members, the sealing members may be heat sealed together without use of a sealing agent. Examples of the sealing agent that may be used include a UV-curable resin, a thermosetting resin, and a two-component curable resin.

A moisture absorber or an inert liquid may be inserted into a space between a sealing vessel and an organic EL device. The moisture absorber is not particularly limited, and specific examples thereof include barium oxide, sodium oxide, potassium oxide, calcium oxide, sodium sulfate, calcium sulfate, magnesium sulfate, phosphorus pentoxide, calcium chloride, magnesium chloride, copper chloride, cesium fluoride, niobium fluoride, calcium bromide, vanadium bromide, molecular sieve, zeolite, and magnesium oxide. Examples of the inert liquid that can be used include paraffins, liquid paraffins, a fluorine-based solvent (such as perfluoroalkane, perfluoroamine, or perfluoroether), a chlorine-based solvent, and silicone oils.

The present invention can provide an organic EL device with excellent degree of whiteness, luminous efficiency, and device life time by suppressing Dexter transfer of triplet energy while a carrier balance between a light-emitting layer containing a fluorescent dopant and a light-emitting layer containing a phosphorescent layer is maintained.

### EXAMPLES

Hereinafter, the present invention will be described in more detail with reference to examples and comparative examples. However, those are mere examples and the present invention is not limited to the examples.

### Example 1

A transparent glass substrate (11), on one of whose surfaces anode (12) made of an ITO layer with a thickness of 150 nm had been formed, was washed with an alkali and then with pure water, dried, and then cleaned with UV/ozone.

Then, NPB represented by the following formula (1) as a hole-transporting material was vapor-deposited onto the anode (12) on thus washed substrate (11) in a vacuum vapor deposition apparatus (a carbon crucible, at a vapor deposition rate of 0.1 nm/s, under a vacuum of about 5.0×10⁻⁵ Pa) , to prepare a layer with a thickness of 40 nm as a hole-transporting layer (15).

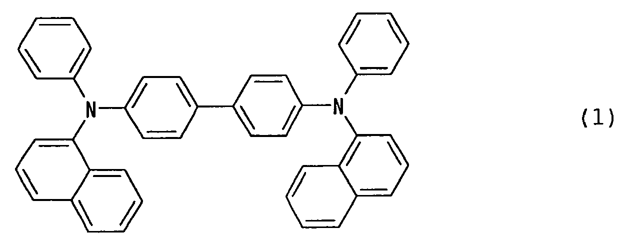

CBP (89.5 wt%) represented by the following formula (2) as a phosphorescent host material, btp2Ir (acac) (0.5 wt%) represented by the following formula (3) as a red phosphorescent dopant, and Ir (ppy) ₃ (10 wt%) represented by the following formula (4) as a green phosphorescent dopant were co-vapor-deposited onto the hole-transporting layer (15) in a vacuum vapor deposition apparatus (a carbon crucible, at a vapor deposition rate of 0.1 nm/s, under a vacuum of about 5.0×10⁻⁵ Pa) , to thereby form a layer with a thickness of 8 nm as a phosphorescent light-emitting layer (16).

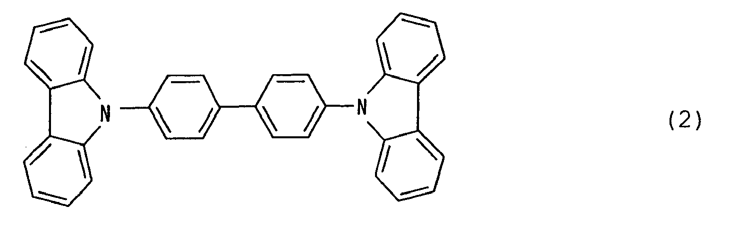

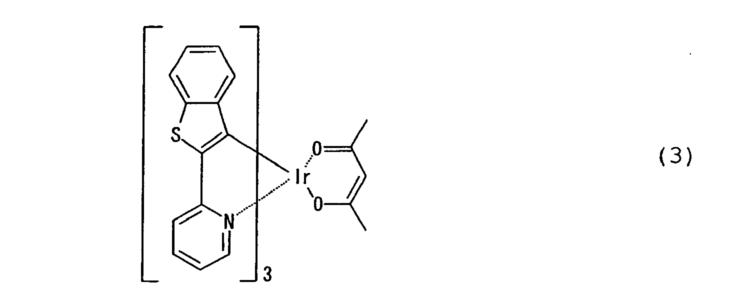

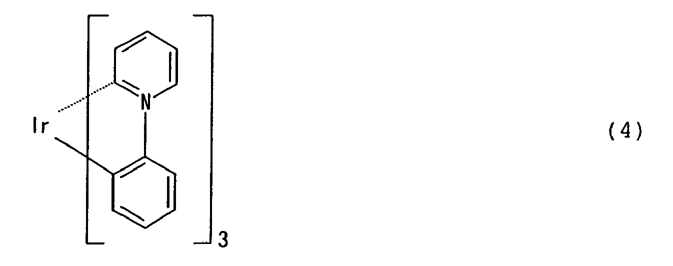

BCP (50 wt%) represented by the following formula (5) as an electron-transporting material, and NPB (50 wt%) represented by the formula (1) as a hole-transporting material were co-vapor-deposited onto the phosphorescent light-emitting layer (16) in a vacuum vapor deposition apparatus (a carbon crucible, at a vapor deposition rate of 0.1 nm/s, under a vacuum of about 5.0x10⁻⁵ Pa), to thereby form a layer with a thickness of 4 nm as a bipolar layer (17).

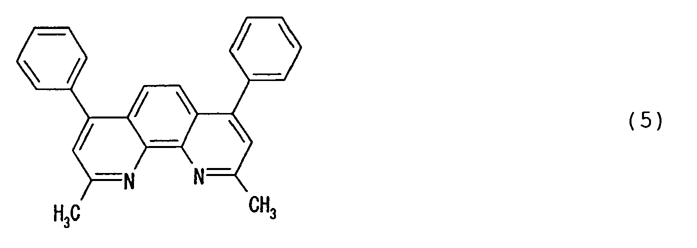

DPVBi (96 wt%) represented by the following formula (6) as a fluorescent host material and BCzVBi (4 wt%) represented by the following formula (7) as a fluorescent dopant were co-vapor-deposited onto the bipolar layer (17) in a vacuum vapor deposition apparatus (a carbon crucible, at a vapor deposition rate of 0.1 nm/s, under a vacuum of about 5.0x10⁻⁵ Pa), to thereby form a layer with a thickness of 20 nm as a fluorescent light-emitting layer (18).

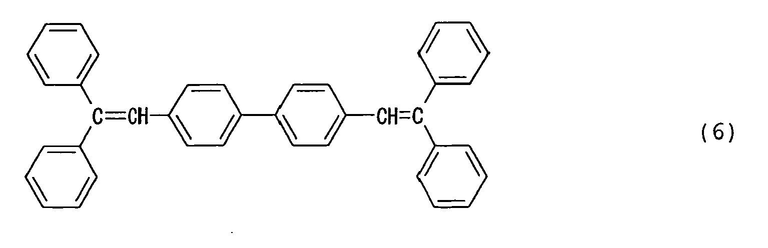

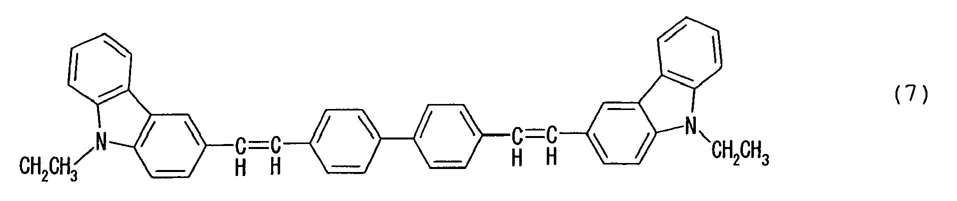

BCP represented by the formula (5) was deposited onto the fluorescent light-emitting layer (18) in a vacuum vapor deposition apparatus (a carbon crucible, at a vapor deposition rate of 0.1 nm/s, under a vacuum of about 5.0×10⁻⁵ Pa), to thereby form a layer with a thickness of 6 nm as a hole-blocking layer.

Alq represented by the following formula (8) was deposited onto the hole-blocking layer in a vacuum vapor deposition apparatus (a carbon crucible, at a vapor deposition rate of 0.1 nm/s, under a vacuum of about 5.0x10⁻⁵ Pa) , to thereby form a layer with a thickness of 24 nm as an electron-transporting layer (19).

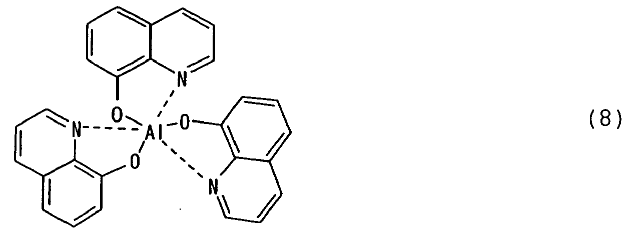

Lithium fluoride (LiF) was deposited onto the electron-transporting layer (19) in a vacuum vapor deposition apparatus (a carbon crucible, at a vapor deposition rate of 0.1 nm/s, under a vacuum of about 5.0x10⁻⁵ Pa), to thereby form a layer with a thickness of 1 nm as an electron-injecting layer.

Aluminum (A1) was deposited onto the electron-inj ecting layer in a vacuum vapor deposition apparatus (a tungsten boat, at a vapor deposition rate of 1 nm/s, under a vacuum of about 5.0x10⁻⁵ Pa), to thereby form a layer with a thickness of 150 nm as a cathode.

An organic EL device was produced as described above, and the anode (12) and the cathode (14) were connected through a known drive circuit. Then, luminous efficiency of the organic EL device was measured in terms of power efficiency at a luminance of 1, 000 cd/m² and a degree of whiteness thereof was also measured at a luminance of 1,000 cd/m². A life time of the organic EL device was measured in terms of initial luminance half-life (time required for reaching a luminance of 1, 200 cd/m², hereinafter, referred to as "half-life") upon continuous supply of a current from an initial luminance of 2, 400 cd/m². Note that luminance was measured with a luminance meter (trade name, BM7, manufacturedby Topcon Corporation). Tablelshows the results.

Abbreviations of compounds used in the following examples and comparative examples will be shown below collectively. The abbreviations correspond to the following respective compounds. Further, the absolute value of HOMO energy level, absolute value of LUMO energy level, and glass transition temperature (Tg) of each of the compounds will be shown.
NPB: N,N'-diphenyl-N,N'-bis(l-naphthyl)-(1,1'-biphenyl)-4,4'-diamin e (HOMO: 5.4 eV, LUMO: 2.4 eV, Tg: 96°C)
BCP: 2,9-dimethyl-4,7-diphenyl-1,10-phenanthroline (HOMO: 6.5 eV, LUMO: 3.0 eV, Tg: 62°C)
CBP: 4,4'-N,N'-dicarbazole biphenyl (Tg: 85°C)
Ir(ppy)₃: iridium fac-tris(2-phenylpyridine)
btp2Ir(acac): iridium bis[2-(2'-benzo[4,5-α]thienyl)pyridinate-N,C^{3'}] acetylacetonate
Alq: aluminium tris(8-quinolinolate) (Tg: 175°C)
BAlq: aluminium bis(2-methyl-8-quinolinolate)(p-phenylphenolate) (HOMO: 5.8 eV, LUMO: 3.0 eV)
SAlq: aluminium (III) bis(2-methyl-8-quinolinate) (HOMO: 6.0 eV, LUMO: 3.0 eV)
TPBI: 2,2',2"-(1,3,5-benzenetriyl)tris-[1-phenyl-1H-benzoimidazole] (HOMO: 5.8 eV, LUMO: 2.8 eV, Tg: 63°C)
OXD-7: 1,3-bis(N,N-t-butyl-phenyl)-1,3,4-oxadiazole (HOMO: 6.4 eV, LUMO: 3.1 eV)
TAZ: 3-phenyl-4-(1'-naphthyl)-5-phenyl-1,2,4-triazole (HOMO: 5.8 eV, LUMO: 2.8 eV)
CuPc: porphyrin-copper (II) complex (HOMO: 5.1 eV, LUMO: 2.1 eV, Tg: 200°C or higher)
NTPA: 4,4'-bis[N-[4'-[N"-(1-naphthyl)-N"-phenylamino]biphenyl]-N-phe nylamino]biphenyl (HOMO: 5.5 eV, LUMO: 2.5 eV, Tg: 148°C)
DPVBi: 4,4'-bis(2,2'-diphenylvinyl)biphenyl
BCzVBi: 4,4'-bis[2-(9-ethylcarbazol-2-yl)vinyl]biphenyl

### Example 2 to 6

In Examples 2 to 6, organic EL devices were produced in the same manner as in Example 1 except that BAlq, SAlq, TPBI, OXD-7, and TAZ were used respectively instead of the electron-transporting material BCP for the bipolar layer (17). The organic EL device produced in each of Examples 2 to 6 was measured for power efficiency, degree of whiteness, and half-life in the same manner as in Example 1. Table 1 shows the results. Note that the power efficiency and half-life are shown as relative values to values of Examples 1. Examples 7 and 8

In Examples 7 and 8, organic EL devices were produced in the same manner as in Example 1 except that CuPc or NTPA was used respectively instead of the hole-transporting material NPB for the bipolar layer (17). The organic EL device produced in each of Examples 7 and 8 was measured forpower efficiency, degree of whiteness, and half-life in the same manner as in Example 1. Table 1 shows the results. Note that the power efficiency and half-life are shown as relative values to values of Examples 1.

**Table 1**

| Example | Structure of bipolar layer | Electric power efficiency | chromaticity x | chromatocity y | Half-life |
|---|---|---|---|---|---|
| 1 | BCP + NPB | 1 | 0.32 | 0.33 | 1 |
| 2 | BAlq + NPB | 0.96 | 0.31 | 0.34 | 1.03 |
| 3 | SAlq + NPB | 0.94 | 0.30 | 0.33 | 0.89 |
| 4 | TPBI + NPB | 0.95 | 0.32 | 0.31 | 0.92 |
| 5 | OXD-7 + NPB | 0.97 | 0.31 | 0.32 | 0.91 |
| 6 | TAZ + NPB | 0.98 | 0.33 | 0.31 | 0.86 |
| 7 | BCP + CuPc | 0.97 | 0.32 | 0.31 | 0.99 |
| 8 | BCP + NTPA | 1 | 0.34 | 0.31 | 1.04 |

### Examples 9 to 12

In Examples 9 to 12, organic EL devices were produced in the same manner as in Example 1 except that a wt% ratio of hole-transporting material : electron-transporting material in the bipolar layer (17) of 50:50 was changed to 80:20, 60:40, 40:60, and 20:80, respectively. The organic EL device produced in each of Examples 9 to 12 was measured for power efficiency, degree of whiteness, and half-life in the same manner as in Example 1. Table 2 shows the results. Note that the power efficiency and half-life are shown as relative values to values of Examples 1.

**Table 2**

| Example | NPB:BCP [wt%] | Electric power efficiency | chromaticity x | chromatocity y | Half-life |
|---|---|---|---|---|---|
| 9 | 80:20 | 0.82 | 0.29 | 0.28 | 0.79 |
| 10 | 60:40 | 0.94 | 0.30 | 0.31 | 0.94 |
| 11 | 40:60 | 0.98 | 0.34 | 0.36 | 0.76 |
| 12 | 20:80 | 0.94 | 0.39 | 0.39 | 0.65 |

### Examples 13 to 16

In Examples 13 to 16, organic EL devices were produced in the same manner as in Example 1 except that the lamination order of the phosphorescent light-emitting layer (16), the bipolar layer (17), and the fluorescent light-emitting layer (18) was changed as shown in Table 3. The organic EL device produced in each of Examples 13 to 16 was measured for power efficiency, degree of whiteness, and half-life in the same manner as in Example 1. Table 3 shows the results. Note that the power efficiency and half-life are shown as relative values to values of Examples 1.

**Table 3**

| Example | Lamination oreder of fluorescent light-emitting layer, bipolar layer, and phosphorescent light-emitting layer (from anode side to cathode side) | Electric power efficiency | chromatocity x | chromatocity y | Half-life |
|---|---|---|---|---|---|
| 13 | Red phosphorescent light-emitting layer/green phosphorescent light-emitting layer/bipolar layer/blue fluorescent light-emitting layer | 0.95 | 0.32 | 0.31 | 0.98 |
| 14 | Blue fluorescent light-emitting layer/bipolar layer/red and green phosphorescent light-emitting layer | 0.77 | 0.30 | 0.32 | 1 |
| 15 | Blue fluorescent light-emitting layer/bipolar layer/green phosphorescent light-emitting layer/red phosphorescent light-emitting layer | 0.75 | 0.32 | 0.33 | 0.92 |
| 16 | Blue fluorescent light-emitting layer/bipolar layer/red phosphorescent light-emitting layer/green phosphorescent light-emitting layer | 0.73 | 0.33 | 0.31 | 0.96 |

### Example 17 and 18

In Examples 17 and 18, organic EL devices were produced in the same manner as in Example 1 except that: the hole-blocking layer and the electron-transporting layer (19) were formed into one layer (codeposition of BCP and Alq) in Example 17; and the hole-blocking layer was omitted in Example 18. The organic EL device produced in each of Examples 17 and 18 was measured for power efficiency, degree of whiteness, and half-life in the same manner as in Example 1. Table 4 shows the results. Note that the power efficiency and half-life are shown as relative values to values of Examples 1.

**Table 4**

| Example | Electric power efficiency | chromaticity x | chromaticity y | Half-life |
|---|---|---|---|---|
| 17 | 1.02 | 0.31 | 0.32 | 0.98 |
| 18 | 0.96 | 0.31 | 0.33 | 1.03 |

In each of Examples 1 to 18, an absolute value of HOMO energy level of the hole-transporting material forming the bipolar layer (17) was smaller than an absolute value of HOMO energy level of the electron-transporting material forming the bipolar layer (17). Further, an absolute value of LUMO energy level of the hole-transporting material forming the bipolar layer (17) was smaller than an absolute value of LUMO energy level of the electron-transporting material forming the bipolar layer (17).

### Comparative Examples 1 to 4

In each of Comparative Examples 1 to 3, organic EL devices were produced in the same manner as in Example 1 except that: the bipolar layer (17) was formed to a thickness of 4 nm by using the hole-transporting material (NPB) alone in Comparative Example 1; the bipolar layer (17) was formed to a thickness of 2 nm by using the hole-transporting material (NPB) alone in Comparative Example 2; and the bipolar layer (17) was formed to a thickness of 4 nm by using the electron-transporting material (BCP) alone in Comparative Example 3. In Comparative Example 4, an organic EL device was produced in the same manner as in Example 1 except that the bipolar layer (17) was not formed. The organic EL device produced in each of Comparative Examples 1 to 4 was measured for power efficiency, degree of whiteness, and half-life in the same manner as in Example 1. Table 5 shows the results. Note that the power efficiency and half-life are shown as relative values to values of Examples 1.

**Table 5**

| Comparative Example | Electric power efficiency | chromaticity x | chromaticity y | Half-life |
|---|---|---|---|---|
| 1 | 0.62 | 0.26 | 0.27 | 0.65 |
| 2 | 0.49 | 0.31 | 0.33 | 0.79 |
| 3 | 0.93 | 0.43 | 0.49 | 0.27 |
| 4 | 0.33 | 0.29 | 0.29 | 0.19 |

Tables 1 to 5 reveal that the organic EL device of each of Examples 1 to 18 in which the bipolar layer (17) was provided between the fluorescent light-emitting layer (18) and the phosphorescent light-emitting layer (16) had better degree of whiteness, luminous efficiency, and half-life than those of Comparative Examples 1 to 4.

An organic EL device including between an anode and a cathode an organic layer including: a light-emitting layer containing a fluorescent dopant; a light-emitting layer containing a phosphorescent dopant; and a bipolar layer, in which the bipolar layer is provided between the light-emitting layer containing a fluorescent dopant and the light-emitting layer containing a phosphorescent dopant.

## Claims

1. An organic EL device comprising between an anode and a cathode an organic layer including:
a light-emitting layer containing a fluorescent dopant;
a light-emitting layer containing a phosphorescent dopant; and
a bipolar layer, wherein
the bipolar layer is provided between the light-emitting layer containing a fluorescent dopant and the light-emitting layer containing a phosphorescent dopant.

2. An organic EL device according to claim 1, wherein the bipolar layer contains a hole-transporting material and an electron-transporting material.

3. An organic EL device according to claim 1, wherein the bipolar layer has a thickness of 2 nm to 15 nm.

4. An organic EL device according to claim 2, wherein the hole-transporting material has a smaller absolute value of highest occupied molecular orbital (HOMO) energy level than an absolute value of highest occupied molecular orbital energy level of the electron-transporting material.

5. An organic EL device according to claim 2, wherein the hole-transporting material has a smaller absolute value of lowest unoccupied molecular orbital (LUMO) energy level than an absolute value of lowest unoccupied molecular orbital energy level of the electron-transporting material.

6. An organic EL device according to claim 2, wherein the hole-transporting material has a higher glass transition temperature than a glass transition temperature of the electron-transporting material.

7. An organic EL device according to claim 1, wherein the light-emitting layer containing a fluorescent dopant is provided closer to the cathode than the light-emitting layer containing a phosphorescent dopant is provided.

8. An organic EL device according to claim 1, wherein the fluorescent dopant comprises a blue fluorescent dopant.

9. An organic EL device according to claim 1, wherein the phosphorescent dopant comprises a red phosphorescent dopant.

10. An organic EL device according to claim 1, wherein the phosphorescent dopant comprises a green phosphorescent dopant.

11. An organic EL device according to claim 1, wherein the light-emitting layer containing a phosphorescent dopant comprises a red phosphorescent dopant and a green phosphorescent dopant.

12. An organic EL device according to claim 11, wherein a content of the red phosphorescent dopant is lower than a content of the green phosphorescent dopant.

13. An organic EL device according to claim 1, wherein the light-emitting layer containing a fluorescent dopant has a larger thickness than a thickness of the light-emitting layer containing a phosphorescent dopant.

14. An organic EL device according to claim 2, wherein the organic layer further includes a hole-transporting layer containing a material identical to the hole-transportingmaterial of the bipolar layer.

15. An organic EL device according to claim 2, wherein the organic layer further includes an electron-transporting layer containing a material identical to the electron-transporting material of the bipolar layer.

16. An organic EL device according to claim 1, wherein the bipolar layer contains a material having a larger triplet energy gap than a triplet energy gap of the phosphorescent dopant.

17. An organic EL device according to claim 2, wherein a content of the electron-transporting material is 5 wt% to 95 wt% with respect to the bipolar layer.
